# EUROPÄISCHE PATENTSCHRIFT

(11) **EP 0 908 927 B1**
(45) Veröffentlichungstag und Bekanntmachung des Hinweises auf die Patenterteilung: **31.01.2007**
(21) Anmeldenummer: 97115686.4
(22) Anmeldetag: 10.09.1997
(51) Int. Cl.: H01L 21/677

(54) **Transfervorrichtung für Halbleiterscheiben**
Semiconductor wafer transfer apparatus
Appareillage de transfert de plaquettes semiconductrices

(43) Veröffentlichungstag der Anmeldung: 14.04.1999
(73) Patentinhaber: Tec-Sem AG, 8274 Tägerwilen (CH)
(72) Erfinder: Blattner, Jakob, 8272 Ermatingen (CH); Bachmann, Rolf, 9215 Schönenberg a.d. Thur (CH); Rüegg, Hanno, 8280 Kreuzlingen (CH)
(74) Vertreter: Klein, Friedrich Jürgen

(56) Entgegenhaltungen:
- EP-A- 0 496 006
- US-A- 4 611 966
- US-A- 4 695 217
- US-A- 4 987 407
- US-A- 5 374 153

## Beschreibung

Die vorliegende Anmeldung betrifft eine Wafer-Transfervorrichtung nach dem Oberbegriff von Anspruch 1 resp. ein Verfahren nach dem Oberbegriff von Anspruch 8.

Eine Wafer-Transfervorrichtung ist beispielsweise aus EP 0 496 006 bekannt. Dort wird eine Vorrichtung beschrieben, bei welcher Wafer von einem oder mehreren Wafer-Halter auf einen Träger übertragen werden, welche wenigstens eine Lade- und eine Entladestation, Hebemittel zum Anheben der Wafer, zwischen den Trägern bewegliche Stützmittel sowie mit diesen verbundene Betätigungsorgane aufweist. Die Betätigungsorgane sind in Form von zylindrischen Rollen ausgeführt, welche an einem Ende drehbar in den Stützmitteln gelagert sind und senkrecht zu ihrer Achse Schlitze zur Führung und Aufnahme der Wafer aufweisen. Im Wafer-Halter, beispielsweise Magazine, sind die Wafer voneinander beabstandet gestapelt aufbewahrt. Der Abstand zwischen den einzelnen Wafern beträgt dabei in der Regel ein Mehrfaches der Dicke der Wafer. Auf dem Träger können die Wafer viel dichter beieinander angeordnet werden, wenn beispielsweise die Wafer zur weiteren Verarbeitung beispielsweise einem Ofen zu Heizzwecken zugeführt werden sollen. Um nun diese Verarbeitung möglichst effizient durchführen zu können, ist es vorteilhaft, die Waferstapel aus den einzelnen Haltern auf dem Träger verdichtet anzuordnen. Hierfür ist die in der erwähnten Patentschrift vorgeschlagenen Lösung geeignet.

Eine solche Vorrichtung weist nun den Nachteil auf, dass sie nur eingesetzt werden kann, um zwei Waferstapel ineinander versetzt angeordnet zu vereinen. D.h. es kann eine maximal Verdichtung von 1 : 2 erreicht werden.

Die Aufgabe der vorliegenden Erfindung lag nun darin, eine Vorrichtung der genannten Art zu finden, welche geeignet ist, drei oder mehr Waferstapel zuverlässig und sicher ineinander versetzt angeordnet zu vereinen.

Diese Aufgabe wird erfindungsgemäss durch die Merkmale des Anspruchs 1 gelöst. Bevorzugte Ausführungsformen ergeben sich aus den abhängigen Ansprüchen 2 bis 7. Weiter wird die Aufgabe erfindungsgemäss durch Merkmale des Verfahrens nach Anspruch 8 gelöst. Bevorzugte Ausführungsformen des Verfahrens ergeben sich aus den abhängigen Ansprüchen 9 bis 11.

Der grosse Vorteil der erfindungsgemässen Vorrichtung resp. des erfindungsgemässen Verfahrens liegt darin, dass nur eine Vertikalbewegung zwischen zwei definierten Endpositionen durchgeführt werden muss, um eine praktisch beliebige Anzahl von Waferstapel ineinander zu verdichten. Damit können auf einfache und schnelle Art genau positionierte, verdichtete Waferstapel erzielt werden, und auch anschliessend an einen Bearbeitungsprozess wieder den einzelnen Haltevorrichtungen resp. Magazinen zugeführt werden. Die geforderte Positioniergenauigkeit lässt sich durch die Verwendung von nur zwei Endanschlägen zuverlässig über lange Zeit reproduzieren, was bei einer sequentiellen Ansteuerung von einzelnen Positionen nicht mit dieser Genauigkeit und Zuverlässigkeit erzielt werden könnte. Zudem ist diese Vorrichtung sehr einfach für unterschiedliche Verdichtungsstufen konfigurierbar. Vorzugsweise wird bei üblichen Magazinen für Wafer und die damit vorgegebenen Wafer-Abstände eine Verdichtung von 1 : 3 erreicht.

Ein Ausführungsbeispiel der Erfindung wird nachstehend anhand von Figuren der beiliegenden Zeichnungen noch näher erläutert. Es zeigen
Fig. 1 - 6 jeweils die Seitenansicht, Vorder- und Aufsicht auf eine erfindungsgemässe Transfervorrichtung für das dreifache Verdichten von jeweils gleichzeitig aus zwei Magazinen stammenden Wafer-Stapeln;
Fig. 1 vor der Aufnahme der ersten Stapel;
Fig. 2 bei der Aufnahme der zweiten Stapel;
Fig. 3 bei der Aufnahme der dritten Stapel;
Fig. 4 beim Zusammenführen der dreifach verdichteten Stapel zu einem Stapel;
Fig. 5 beim Ablegen des verdichteten Stapels für die Weiterverarbeitung;
Fig. 6 beim Zuführen eines bearbeiteten, verdichteten Stapels in die Vorrichtung;
Fig. 7 die Aufsicht auf eine Rolle der Halterung;
Fig. 8 der Querschnitt A-A durch die Rolle von Figur 7;
Fig. 9 der Querschnitt B-B durch die Rolle von Figur 7; und
Fig. 10 die schematische Aufsicht auf eine Anordnung einer erfindungsgemässen Austauschvorrichtung.

Die folgende Beschreibung stützt sich auf die Figurenfolge 1 bis 6, in welcher jeweils auf der linken Seite die Seitenansicht und auf der rechten Seite jeweils ein resp. zwei Vorderansicht und Aufsicht auf eine erfindungsgemässe Vorrichtung dargestellt sind.

Die Vorrichtung weist als Zwischenlagerstelle eine mit zwei parallel zueinander angeordneten und rotierbaren Rollen 1,2 versehene Halterung 3 auf. Die Rollen 1,2 sind derart in an sich bekannter Weise beabstandet angeordnet, dass Wafer 4 in am Umfang der Rollen 1,2 angebrachten Schlitzen gehalten werden, aber durch tangential zur Rollenachse vertiefte Schlitze von unten resp. von oben zwischen den beiden Rollen 1,2 hindurch bewegt werden können, wie nachfolgend noch näher erläutert werden wird.

Unterhalb der Halterung 3 sind parallel zur Rollenachse bezüglich der Halterung 3 verschiebbare und in der Höhe verstellbare Hebevorrichtungen 5,6 angeordnet, welche einen vertikal ausgerichteten Haltekamm 7,8 aufweisen, in welchen die Wafer 4 vertikal ausgerichtet gehalten werden können.

In der dargestellten Ausführungsvariante mit zwei parallel zueinander angeordneten Hebevorrichtungen 5,6 sind diese zusätzlich gegeneinander parallel zur Rollenachse verschiebbar ausgeführt, beispielsweise durch Stellmittel 9.

Die Rollen 1,2 weisen nun erfindungsgemäss wenigsten über eine Teil des Umfangs nach Massgabe der Verdichtung beabstandete, ein bestimmte Tiefe aufweisende Ringnuten 10 auf. Der Abstand dieser Ringnuten 10 richtet sich nach den nach der Verdichtung der Wafer 4 zu erreichenden Abstände der Wafer 4 für die weitere Verarbeitung und beträgt einen ganzzahligen Bruch des Abstandes der Wafer 4 in ihrem Transportbehälter. Der Haltekamm 7 resp. 8 der Hebevorrichtung 5 resp. 6 weist eine entsprechende Abstände aufweisende Verzahnung für die Aufnahme der Wafer 4 auf.

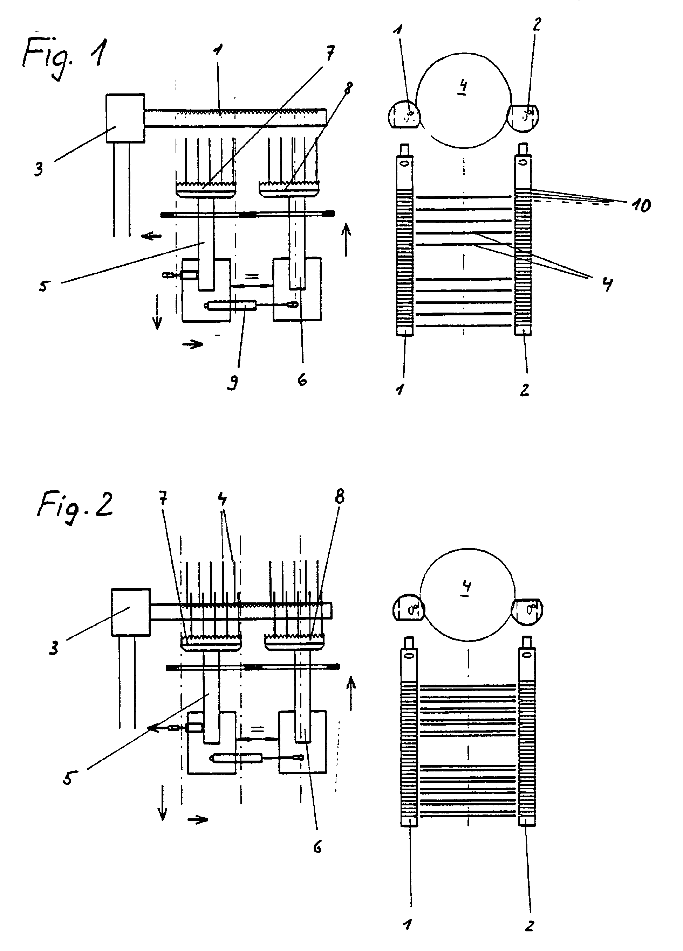

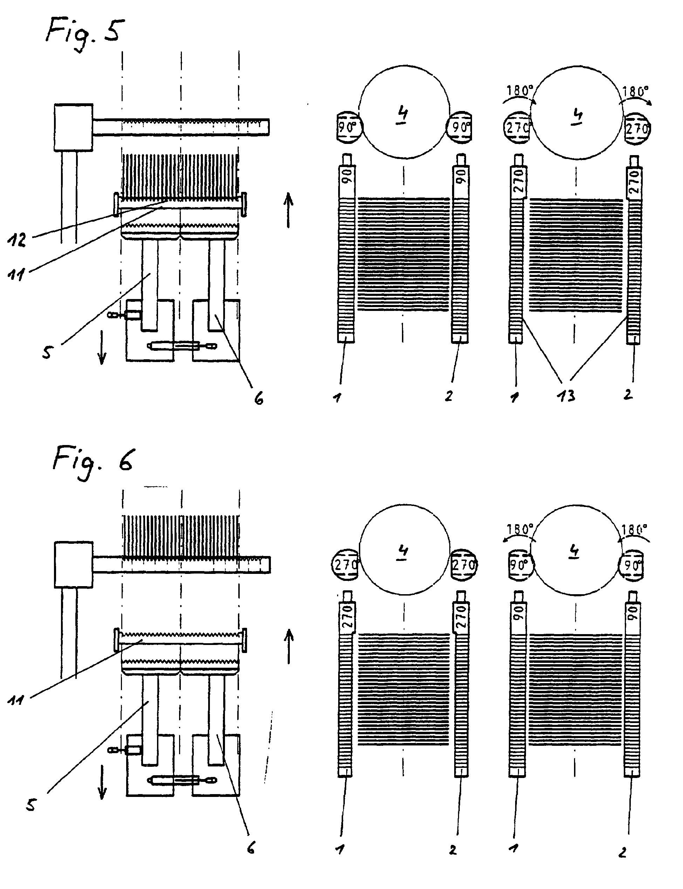

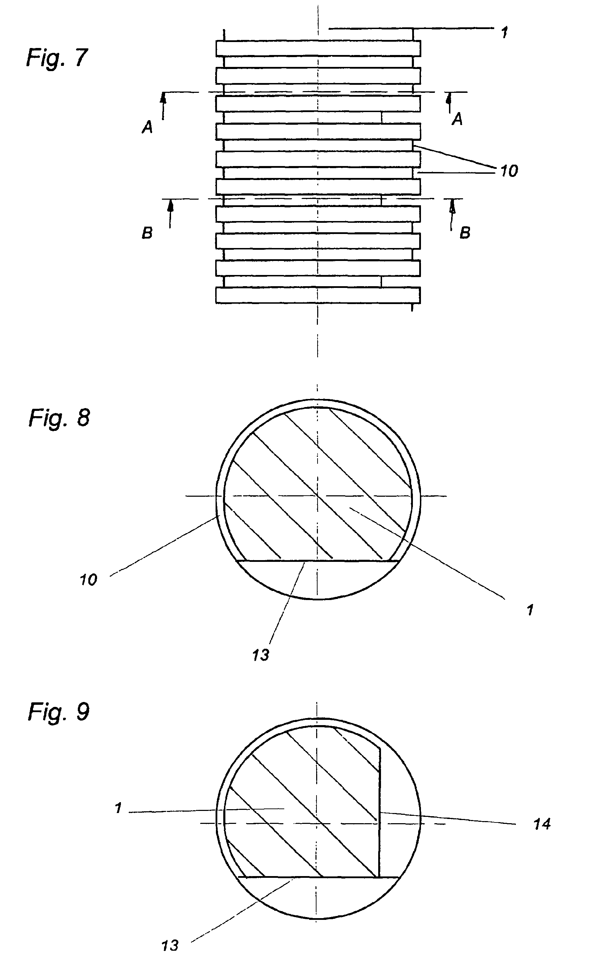

Im dargestellten Ausführungsbeispiel ist die Vorrichtung zur Erzielung einer dreifachen Verdichtung konzipiert, d.h. dass die aus ihren Magazinen durch eine Entnahmevorrichtung (nicht dargestellt) auf den Haltekamm 7 resp. 8 der Hebevorrichtung 5 resp. 6 abgelegten Wafer 4 jeweils in jeder dritten Nut des Haltekammes 7 resp. 8 vertikal zu stehen kommen, wie in Figur 1 dargestellt ist. Es ist selbstverständlich, dass die Breite des Haltekammes 7 resp. 8 auf die Breite des durch die Wafer 4 eines Magazines gebildeten Waferstapels ausgelegt ist, welches je nach dem Typ des Wafers standardisiert ist. Der Übersichtlichkeit halber werden in den folgenden Figuren derartige Stapel durch lediglich 5 Wafer dargestellt. In dieser Figur werden nun die jeweils eine Waferstapel haltenden Hebevorrichtungen 5 und 6 unter die Halterung 3 verfahren. Damit nun die Hebevorrichtungen 5,6 die Wafer 4 zwischen den Rollen 1,2 hindurch anheben können, sind diese in ihre Ausgangsposition (0°) verdreht positioniert. In dieser Position weist jeweils jede dritte Ringnut 10 eine zusätzliche, eine vertikalen Schlitz 14 bildende Vertiefung auf, durch welche hindurch die Wafer 4 mittels der Hebevorrichtungen 5,6 angehoben werden können. Anstelle dieser Ausgangsposition (0°) kann der Prozess auch mit der in Figur 5 resp. 6 dargestellten Endposition (270°) gestartet werden, welche nachfolgend noch näher erläutert wird. Nach dem Anheben der Hebevorrichtungen 5,6 würden danach die beiden Rollen 1,2 in die Ausgangsposition (0°) verschwenkt werden.

Die Hebevorrichtung 5,6 ist für diesen Vorgang jeweils am in Figur 1 dargestellten vorderen Anschlag positioniert, und wird nach erfolgtem Anheben an seinen hinteren Anschlag positioniert, welcher um den Abstand der Ringnuten 10 verschoben angeordnet ist. In dieser hinteren Position wird die Hebevorrichtung 5,6 wieder abgesenkt, worauf die Wafer 4 mit den jeweiligen Ringnuten 10 in Eingriff gelangen und darin gehalten werden, während die Hebevorrichtung 5,6 wieder vollständig abgesenkt werden.

Der oben beschriebene Vorgang wird nun mit den nächsten beiden Waferstapeln wiederholt, wie in Figur 2 dargestellt ist. Hier ist nun der Moment des Anhebens der Hebevorrichtungen 5,6 wiederum in der vorderen Position abgebildet, wobei die Wafer 4 der zweiten Waferstapel wiederum durch die Schlitze der Rollen 1,2 hindurch nach oben angehoben werden. Auf der Höhe der bereits in den Rollen 1,2 gelagerten ersten Waferstapel werden diese Wafer 4 nun ebenfalls mit angehoben, da der entsprechende Haltekamm 7 resp. 8 ebenfalls mit entsprechenden Schlitzen versehen ist. Durch die erneute Verschiebung der Hebevorrichtung 5,6 in die hintere Position werden nun beide Waferstapel, der erste und der zweite Waferstapel jeweils um eine Position nach hinten verschoben und bleiben beim anschliessenden Absenken der Hebevorrichtung 5,6 beide in den Ringnuten 10 der Rollen 1,2 vertikal gehalten.

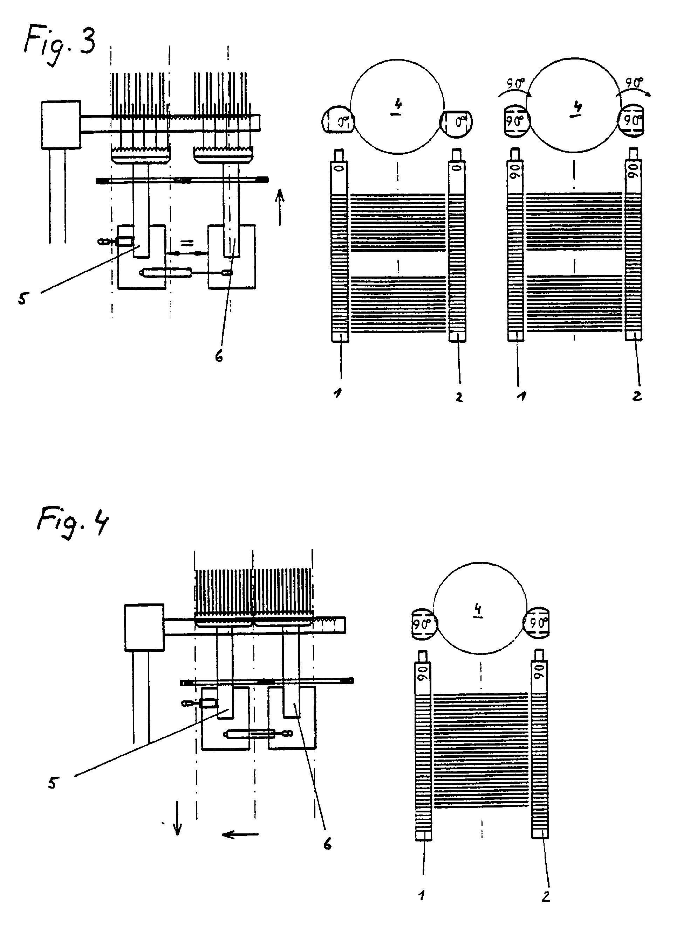

Nun können anschliessend auf dieselbe Weise die dritten Waferstapel durch die Hebevorrichtungen 5,6 zwischen die Rollen 1,2 angehoben werden, wie in Figur 3 dargestellt ist. Dies erfolgt wiederum in der vorderen Anschlagposition der Hebevorrichtungen 5,6. Nun wird die Hebevorrichtung 5,6 in dieser vorderen Anschlagposition belassen und die Rollen 1,2 um 90° in die erste Halteposition (90°) verschwenkt. In dieser Position sind alle Ringnuten 10 derart ausgebildet, dass die Wafer 4 von oben darin vertikal gehalten werden können. Dabei sind nun alle drei Waferstapel, d.h. alle Wafer 4, im Haltekamm 7 resp. 8 gehalten, und die beiden Hebevorrichtungen 5 und 6 werden nun gegeneinander aneinander verschoben. Vorzugsweise wird dabei die erste Hebevorrichtung 5 in der Position belassen und nur die zweite Hebevorrichtung 6 derart gegen die erste Hebevorrichtung 5 verschoben, dass der letzte resp. erste Wafer 10 der beiden Haltekämme 7 resp. 8 direkt nebeneinander zu stehen kommen, wie in Figur 4 dargestellt. Nun können die Hebevorrichtungen 5 resp. 6 wieder vollständig abgesenkt werden, wodurch alle Wafer 4 nebeneinander verdichtet auf den Rollen 1,2 angeordnet sind.

Die derart zu einem einzigen, verdichteten Waferstapel angeordneten Wafer 4 können nun in einer Haltevorrichtung 11, welche analog der Hebevorrichtungen 5 resp. 6 mit einem Haltekamm 12 ausgebildet ist, aufgenommen werden und zur Weiterverarbeitung einem Bearbeitungsprozess zugeführt werden, wie in Figur 5 dargestellt. Sobald die Wafer 4 mit dem Haltekamm 12 in Kontakt stehen und angehoben sind, werden die beiden Rollen 1,2 um weitere 180° in ihre Entnahmeposition (270°) verschwenkt. In dieser Position weist die Wandung der Rollen 1,2 eine vertikal stehend ausgebildete Abflachung 13 auf, womit die Wafer 4 unter die Ebene der Rollen 1,2 abgesenkt werden können. Selbstverständlich könnten in dieser Position anstelle der Abflachung 13 auch alle Ringnuten 10 entsprechend der Position 0° Schlitze aufweisen, aber die dargestellte Abflachung 13 wird als einfachere Ausführung bevorzugt.

Nach dem Ende des Bearbeitungsprozesses können die Wafer 4 mit der Haltevorrichtung 11 wieder den Rollen 1,2 zugeführt werden und der oben beschriebenen Prozess in umgekehrter Reihenfolge zur Entnahme der Wafer 4 und Rückführung in die einzelnen Magazine mit grösserem, ursprünglichen (hier dreifachen) Abstand zurückgeführt werden.

In Figur 7 ist nun noch die detaillierte Aufsicht auf die Rolle 1 dargestellt, aus welcher die Anordnung der Ringnuten 10 noch besser ersichtlich ist. In den Figuren 8 und 9 sind ferner noch die Querschnitte durch die Stellen A-A resp. B-B dargestellt, und zwar in der Stellung 0°. In dieser Stellung ist die abgeflachte Seite, d.h. die Abflachung 13, nach unten weisend ersichtlich. Jede dritte Ringnut 10 weist einen zusätzlichen, senkrecht zur Abflachung 13, nach Innen sehnenartig vertieften Schlitz 14 auf, damit die Wafer 4 an diesen Positionen zwischen den beiden Rollen 1,2 hindurch nach oben resp. unten transportiert werden können, wobei die Wafer 4 in den übrigen Ringnuten 10 gehalten sind.

Es ist klar, dass sich derselbe Ablauf auch für eine anderes Verdichtungsverhältnis als 3:1 eignet, die Grenzen für höhere Verdichtungsverhältnisse ergeben sich praktisch aus der Dicke der Wafer 4 und dem Grundabstand in den Waferhalterungen. Grundsätzlich ist auch die Anwendung als 1:2 Verdichtung denkbar. Der grosser Vorteil des dargestellten Verfahrens resp. der erfindungsgemässen Vorrichtung besteht darin, dass eine hohe, reproduzierbare Genauigkeit erzielt werden kann, da jeder Bewegungsablauf nur zwischen zwei definierten Anschlagspositionen abläuft. Dies ermöglicht andererseits auch sehr hohe Transfergeschwindigkeiten und hohe Betriebszuverlässigkeit der Vorrichtung.

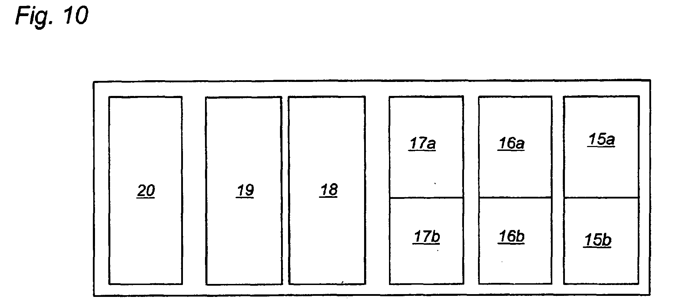

Die Anlage eignet sich für die Zuführung von Waferkassetten entweder manuell oder durch Automaten, wobei die Zuführung jeweils zweier nebeneinanderliegender Kassetten für jeden Verdichtungsschritt einzeln erfolgen kann, oder auf einen vorbereiteten Transferplatz mit beispielsweise sechs hinter- und nebeneinander angeordneten Magazinplätzen für eine 3:1 Verdichtung, wie diese in Figur 10 schematisch in der Aufsicht dargestellt ist. Hier sind rechts die sechs Magazinplätze 15a,15b,16a,16b,17a,17b ersichtlich, daneben zwei Lade- resp. Entladeplätze 18,19 und anschliessend der Transferplatz 20 für den verdichtet angeordneten Waferstapel zur Weiterverarbeitung. Bei einer solchen Anordnung ist nun die Halterung 3 mit den Rollen 1,2 entlang der vorderen oder hinteren Seitenkante über die Magazin-, Lade- und Entlade- und Transferplätze verschiebbar angeordnet. Die Hebevorrichtungen 5,6 können dabei ebenfalls mit verschoben werden oder ggf. an jedem der genannten Plätze angeordnet sein.

Im dargestellten Ausführungsbeispiel werden nur drei um 90° zueinander versetzt angeordnete Positionen der Rollen 1,2 verwendet. Es ist klar, dass anstelle des 90° Winkels auch eine Versetzung von beispielsweise 120° vorgesehen sein kann. Auch können die Ringnuten 10 wie dargestellt über den gesamten Umfang der Rollen 1,2 angeordnet sein, oder nur in den jeweils verwendeten Bereichen.

## Patentansprüche

1. Wafer-Transfervorrichtung zur Uebertragung von in einer Haltevorrichtung beabstandet gestapelt angeordneten Wafern (4) in eine Trägervorrichtung (3), welche zwei parallel zueinander angeordnete und um ihre jeweilige Rollenlängsachse rotierbare Rollen (1,2) mit wenigstens einen Teil des Umfangs der Rollen (1,2) umfassenden Ringnuten (10) zur Aufnahme und Durchführung der Wafer (4) und Hebemittel (5,6) mit kammartigem Auflageelement (7,8) zur vertikalen Aufnahme von Wafern (4) aufweist, **dadurch gekennzeichnet, dass** in einer ersten Position (0°) der Rollen (1,2) die von dem kammartigen Auflageelement (7;8) gehaltenen Wafer (4) durch im Bereich von Ringnuten (10) angeordnete Schlitze (14) zwischen den beiden Rollen (1,2) hindurch vertikal verschiebbar sind, wobei die Schlitze (14) zur Hindurchführung der Wafer entsprechend vertieft und entsprechend dem gewünschten Verdichtungsverhältnis 1:x im Bereich jeder x-ten Ringnut (10) angeordnet sind in einer zweiten Position (90°) die Wafer (4) in vertikaler Ausrichtung in den Ringnuten (10) gehalten sind, und in einer dritten Position (270°) die Rollen (1,2) eine tangential angeordnete Abflachung (13) aufweisen, dass eine beliebige Anzahl Wafer (4) zwischen den beiden Rollen hindurch vertikal verschiebbar sind, und dass weiter die Hebemittel (5,6) horizontal parallel zu den Längsachsen der Rollen (1,2) zwischen zwei Anschlagpositionen im Abstand der in der zweiten Rollenposition (90°) angeordneten Ringnuten (10) vor und rückwärts verschiebbar angeordnet sind.

2. Wafer-Transportvorrichtung nach Anspruch 1, **dadurch gekennzeichnet, dass** die Rollenpositionen jeweils um 90° verdreht voneinander angeordnet sind.

3. Wafer-Transportvorrichtung nach Anspruch 1, **dadurch gekennzeichnet, dass** die dritte Position (270°) 180° gegenüber der zweiten Position (90°) angeordnet ist, d.h. dass die Abflachung (13) bezüglich der Ringnuten (10) ohne zusätzlichen Vertiefungsschlitze (14) auf der gegenüberliegenden Seite der Rollen (1,2) angeordnet ist.

4. Wafer-Transportvorrichtung nach einem der Ansprüche 1 bis 3, **dadurch gekennzeichnet, dass** jeweils zwei miteinander verschiebbar verbundene Hebemittel (5,6) angeordnet sind.

5. Wafer-Transportvorrichtung nach einem der Ansprüche 1 bis 4, **dadurch gekennzeichnet, dass** ein pneumatischer oder elektrischer Antrieb zur Verschiebung der Hebemittel (5,6) vorgesehen ist.

6. Wafer-Transportvorrichtung nach einem der Ansprüche 1 bis 5, **dadurch gekennzeichnet, dass** in der ersten Position (0°) der Rollen (1,2) die Abflachung (13) jeweils einer Rolle (1) nach unten und der anderen Rolle (2) nach oben ausgerichtet ist.

7. Wafer-Transportvorrichtung nach einem der Ansprüche 1 bis 6, **dadurch gekennzeichnet, dass** die Rollen (1,2) mit derselben Drehrichtung angetrieben sind.

8. Verfahren zur Uebertragung von vertikal beabstandet gestapelt angeordneten Wafern (4) von einer oder mehreren Haltevorrichtungen auf eine Trägervorrichtung (3) mit zwei parallel zueinander angeordneten und um ihre jeweilige Rollenlängsachse rotierbaren Rollen (1,2) mit wenigstens über einen Teil eines Umfangs der Rollen (1,2) angeordneten Ringnuten (10) zur Aufnahme und Durchführung der Wafer (4), **dadurch gekennzeichnet, dass** jeweils mindestens ein Wafer-Stapel mittels einer kammartige Auflagemittel (7,8) aufweisender Hebevorrichtung (5,6) aus der Haltevorrichtung angehoben wird, danach die Hebevorrichtung (5,6) unter die Trägervorrichtung (3) verfahren wird oder umgekehrt, wobei die Hebevorrichtung (5,6) in einer bezüglich der Rollenlängsachsen orderen horizontalen Anschlagstellung positioniert wird, und dann die Auflagemittel (7,8) angehoben werden, wobei die Rollen (1,2) der Trägervorrichtung (3) entweder in einer Ausgangsposition (0°) oder einer zweiten Position (270°) verdreht sind, in welcher die Wafer (4) durch Schlitze (14) oder zwischen Abflachungen (13) der Rollen (1,2) durch die Rollen (1,2) hindurch vertikal nach oben durchgeschoben werden können, und danach die Trägervorrichtung (3) in eine bezüglich der Rollenlängsachsen hintere horizontale Anschlagstellung verfahren wird, worauf die Rollen (1,2) der Trägervorrichtung (3) in eine Ausgangsposition (0°) verdreht werden oder diese beibehalten wird, in welcher anschliessend an die mit Schlitzen (14) versehenen Ringnuten (10) weitere Ringnuten (10) angeordnet sind, in welchen nach dem Absenken der Auflagemittel (7,8) die Wafer (4) in vertikaler Ausrichtung gehalten werden, und dass dieser Vorgang solange wiederholt wird, bis die gewünschte Verdichtung der Wafer erreicht ist.

9. Verfahren nach Anspruch 8, **dadurch gekennzeichnet, dass** gleichzeitig mehrere, vorzugzugsweise zwei, Waferstapel jeweils gemeinsam angehoben werden und nach dem letzten Anhebevorgang die Hebevorrichtungen (5,6) horizontal zusammengeschoben werden und danach abgesenkt werden, um einen einzigen, verdichteten Waferstapel zu bilden und auf den Rollen (1,2) abzulegen.

10. Verfahren nach Anspruch 8 oder 9, **dadurch gekennzeichnet, dass** der Vorgang dreimal nacheinander ausgeführt wird, um eine dreifache Verdichtung zu erzielen.

11. Verfahren nach einem der Ansprüche 8 bis 10, **dadurch gekennzeichnet, dass** Hebevorrichtung (5,6) jeweils nach dem Absenken wieder in die vordere horizontale Anschlagstellung positioniert wird.

## Claims

1. A wafer transfer device for transferring wafers (4) stacked spaced from one another in a holding device into a carrier device (3), which has two rollers (1,2) disposed parallel to one another rotatably around their respective longitudinal axes with annular grooves (10) covering at least part of the perimeter of the rollers (1,2) to receive and transport the wafers (4) and lifting means (5,6) with a comb-shaped support element (7,8) for receiving wafers (4) vertically, **characterised in that** with the rollers (1,2) in a first position (0°), the wafers (4) held by the comb-shaped support element (7,8) can be moved vertically through slots (14) in the area of annular grooves (10) between the two rollers (1,2), wherein the slots (14) are sufficiently deepened to allow the wafers to pass through and are disposed in the area of every x^{th} annular groove (10) in accordance with the required compression ratio 1:x, in a second position (90°) the wafers (4) are held vertically in the annular grooves (10) and in a third position (270°) the rollers (1,2) have a tangentially disposed flat portion (13), that any number of wafers (4) can be moved vertically between the two rollers and that furthermore the lifting means (5,6) are horizontally disposed parallel to the longitudinal axes of the rollers (1,2) between two stop positions at a distance from the annular grooves (10) disposed in the second roller position (90°), so that they are movable forwards and backwards.

2. The wafer transport device according to claim 1, **characterised in that** the roller positions are each disposed at 90° to one other.

3. The wafer transport device according to claim 1, **characterised in that** the third position (270°) is disposed at 180° to the second position (90°), i.e. the flat portion (13) is disposed on the opposite side of the rollers (1,2) relative to the annular grooves (10) without additional deepened slots (14).

4. The wafer transport device according to one of the claims 1 to 3, **characterised in that** lifting means (5,6) movably connected to one another are disposed in twos.

5. The wafer transport device according to one of the claims 1 to 4, **characterised in that** a pneumatic or electrical drive is provided to move the lifting means (5,6).

6. The wafer transport device according to one of the claims 1 to 5, **characterised in that** with the rollers (1,2) in the first position (0°) the flat portion (13) is facing down on one roller (1) and up on the other roller (2).

7. The wafer transport device according to one of the claims 1 to 6, **characterised in that** the rollers (1,2) are driven in the same rotational direction.

8. A method for transferring wafers (4) stacked vertically spaced from one another from one or several holding devices to a carrier device (3) with two rollers (1,2) disposed parallel to one another rotatably around their respective longitudinal axes with annular grooves (10) covering at least part of the perimeter of the rollers (1,2) to receive and transport the wafers (4), **characterised in that** at least one wafer stack in each case is lifted from the holding device by way of a lifting device (5,6) with a comb-shaped support means (7,8), after which the lifting device (5,6) is moved under the carrier device (3) or vice versa, wherein the lifting device (5,6) is positioned in a horizontal stop setting relative to the longitudinal axes of the rollers and then the support means (7,8) are raised, wherein the rollers (1,2) of the carrier device (3) are turned into either a starting position (0°) or a second position (270°), in which the wafers (4) can be pushed up vertically through slots (14) or through the rollers (1,2) between flat portions (13) of the rollers (1,2) and thereafter the carrier device (3) is moved into a rear horizontal stop position relative to the longitudinal axes of the rollers, whereupon the rollers (1,2) of the carrier device (3) are turned into a starting position (0°) or this position is retained in which further annular grooves are then disposed on the annular grooves (10) with slots (14), in which the wafers (4) are held vertically after the support means (7,8) have been lowered and that this process is repeated until the desired wafer compression is reached.

9. The method according to claim 8, **characterised in that** several, preferably two, wafer stacks are each raised together simultaneously and after the last lifting process the lifting devices (5,6) are pushed together horizontally and then lowered, in order create a single, compressed wafer stack and deposit it on the rollers (1,2).

10. The method according to claim 8 or 9, **characterised in that** the process is carried out three times in succession, in order to achieve a triple compression.

11. The method according to one of the claims 8 to 10, **characterised in that** the lifting device (5,6) is positioned back in the front horizontal stop setting after lowering in each case.

## Revendications

1. Dispositif de transport de pastilles pour le transfert de pastilles (4) disposées empilées à distance dans un dispositif de retenue à un dispositif de support (3) qui présente deux galets rotatifs (1, 2) autour de leurs axes respectifs longitudinaux et disposés parallèlement entre eux avec des rainures annulaires (10) entourant au moins une partie de la périphérie des galets (1, 2) pour le logement et le passage des pastilles (4) et des moyens de levage (5, 6) avec des éléments d'appui (7, 8) en forme de peigne pour la réception verticale de pastilles (4), **caractérisé en ce que** dans une première position (0°) des galets (1, 2), les pastilles (4) maintenues par l'élément d'appui en forme de peigne (7, 8) sont coulissantes verticalement par des fentes (14) disposées dans la zone de rainures annulaires (10) entre les deux galets (1, 2), les fentes (14) étant plus profondes pour le passage des pastilles et étant disposées en fonction du rapport de densification souhaité 1:x dans la zone de chaque rainure annulaire (10), **en ce que** dans une seconde position (90°), les pastilles (4) sont maintenues dans une orientation verticale dans les rainures annulaires (10) et dans une troisième position (270°), les galets (1, 2) présentent un aplanissement (13) disposé tangentiellement, **en ce qu'**un nombre quelconque de pastilles (4) sont coulissantes verticalement entre les deux galets et **en ce que** les moyens de levage (5, 6) sont disposés horizontalement parallèlement aux axes longitudinaux des galets (1, 2) entre deux positions de butée à distance des rainures annulaires (10) disposées dans la seconde position de galet (90°) et sont coulissants en avant et en arrière.

2. Dispositif de transport de pastilles selon la revendication 1, **caractérisé en ce que** les positions de rouleaux sont disposés décalés respectivement de 90°.

3. Dispositif de transport de pastilles selon la revendication 1, **caractérisé en ce que** la troisième position (270°) est disposée à 180 ° par rapport à la seconde position (90°), c'est-à-dire que l'aplanissement (13) par rapport aux rainures annulaires (10) sans fentes supplémentaires de cavité (14) est disposé sur la face opposée des galets (1, 2).

4. Dispositif de transport de pastilles selon l'une des revendications 1 à 3, **caractérisé en ce que** respectivement deux moyens de levage (5, 6) sont disposés reliés entre eux de manière coulissante.

5. Dispositif de transport de pastilles selon l'une des revendications 1 à 4, **caractérisé en ce qu'**un entraînement pneumatique ou électrique est prévu pour le déplacement des moyens de levage (5, 6).

6. Dispositif de transport de pastilles selon l'une des revendications 1 à 5, **caractérisé en ce que** dans la première position (0°) des galets (1,2), l'aplanissement (13) respectivement d'un galet (1) est orienté vers le bas et celui de l'autre galet (2) vers le haut.

7. Dispositif de transport de pastille selon l'une des revendications 1 à 6, **caractérisé en ce que** les galets (1, 2) sont entraînés dans le même sens de rotation.

8. Procédé pour le transfert de pastilles (4) disposées espacées en pile verticalement par un ou plusieurs dispositifs de retenue à un dispositif porteur (3) avec des galets (1, 2) rotatifs autour de leurs axes longitudinaux respectifs et disposés parallèlement entre eux, avec des rainures annulaires (10) disposées au moins sur une partie d'une périphérie des galets (1, 2) pour la réception et le passage des pastilles (4), **caractérisé en ce que** respectivement au moins une pile de pastilles est soulevée du dispositif de retenue à l'aide d'un dispositif de levage (5, 6) présentant des moyens d'appui (7, 8) en forme de peigne, ensuite le dispositif de levage (5, 6) est déplacé en dessous du dispositif porteur (3) ou inversement, le dispositif de levage (5, 6) étant positionné dans une position de butée horizontale par rapport aux axes longitudinaux des galets et ensuite les moyens d'appui (7, 8) étant soulevés, les galets (1, 2) du dispositif porteur (3) étant tournés soit dans une position de départ (0°) soit dans une seconde position (270°), dans laquelle les pastilles (4) peuvent être passées par des fentes (14) ou entre des aplanissements (13) des galets (1, 2) en traversant les galets (1, 2) verticalement vers le haut, et ensuite le dispositif porteur (3) étant déplacé dans une position de butée horizontale arrière par rapport aux axes longitudinaux de galet, les galets (1, 2) du dispositif de support (3) étant tournés dans une position de départ (0°) ou bien la conservant, position dans laquelle d'autres rainures annulaires (10) sont disposées dans la continuité des rainures annulaires (10) munies de fentes (14) rainures dans lesquelles après l'abaissement des moyens d'appui (7, 8), les pastilles (4) sont maintenues dans une orientation verticale et **en ce que** cette procédure est répétée jusqu'à ce que la densification souhaitée des pastilles soit atteinte.

9. Procédé selon la revendication 8, **caractérisé en ce qu'**en même temps plusieurs, de préférence deux piles de lentilles sont soulevées respectivement en commun et après la dernière procédure de soulèvement, les dispositifs de levage (5, 6) sont assemblés horizontalement et sont ensuite abaissés pour former une pile unique de pastilles densifiées et la déposer sur les galets (1, 2).

10. Procédé selon la revendication 8 ou 9, **caractérisé en ce que** l'opération est réalisée trois fois successivement pour obtenir une densification triple.

11. Procédé selon l'une des revendications 8 à 10, **caractérisé en ce que** le dispositif de levage (5, 6) est positionné respectivement après l'abaissement à nouveau dans la position de butée avant horizontale.
